(19) Europäisches Patentamt
European Patent Office
Office européen des brevets

(11) **EP 2 593 798 B1**

(12) **EUROPÄISCHE PATENTSCHRIFT**

(45) Veröffentlichungstag und Bekanntmachung des Hinweises auf die Patenterteilung:
**30.10.2013   Patentblatt 2013/44**

(21) Anmeldenummer: **12753395.8**

(22) Anmeldetag: **06.08.2012**

(51) Int Cl.:
**G01R 1/20** (2006.01)        **G01R 19/25** (2006.01)

(86) Internationale Anmeldenummer:
**PCT/EP2012/003357**

(87) Internationale Veröffentlichungsnummer:
**WO 2013/020698 (14.02.2013 Gazette 2013/07)**

(54) **DIFFERENZSTROMSENSOR**

DIFFERENTIAL CURRENT SENSOR

DÉTECTEUR DE COURANT DIFFÉRENTIEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.09.2011   DE 102011113002**

(43) Veröffentlichungstag der Anmeldung:
**22.05.2013   Patentblatt 2013/21**

(73) Patentinhaber: **Isabellenhütte Heusler GmbH & Co.KG**
**35683 Dillenburg (DE)**

(72) Erfinder: **HETZLER, Ullrich**
**35688 Dillenburg-Oberscheld (DE)**

(74) Vertreter: **Beier, Ralph**
**V. Bezold & Partner**
**Patentanwälte**
**Akademiestraße 7**
**80799 München (DE)**

(56) Entgegenhaltungen:
**WO-A1-00/00834        US-A- 5 319 370**
**US-A1- 2007 208 520**

**Beschreibung**

Die Erfindung betrifft einen Differenzstromsensor, insbesondere für ein Gleichstromnetz.

Aus WO 00/00834 A1 ist ein derartiger Differenzstromsensor bekannt, der beispielsweise in einem einphasigen Wechselstromnetz eingesetzt werden kann, um die elektrischen Ströme in Hin- und Rückleiter zu messen, so dass daraus ein Differenzstrom berechnet werden kann, um einen Fehler erkennen zu können. Die eigentliche Strommessung erfolgt hierbei gemäß der an sich bekannten Vierleitertechnik durch niederohmige Strommesswiderstände, die in dem Hinleiter bzw. in dem Rückleiter angeordnet sind und von den zu messenden elektrischen Strömen durchflossen werden, so dass der Spannungsabfall über den Strommesswiderständen ein Maß für den jeweiligen Strom bildet. Dieser bekannte Differenzstromsensor weist zusätzlich einen ASIC (ASIC: Application Specific Integrated Circuit) auf, der die Spannung über den beiden Strommesswiderständen im Hin- und Rückleiter misst und daraus den Differenzstrom berechnet. Darüber hinaus ermöglicht dieser bekannte Differenzstromsensor eine Kalibrierung der Spannungsmessungen an den beiden Strommesswiderständen, indem der ASIC jeweils masseseitig und spannungsseitig eine Spannungsreferenz misst, die von einem Spannungsteiler zwischen Hinleiter und Rückleiter bereitgestellt wird. Die Messung der Spannungsreferenzen durch den ASIC erfolgt hierbei innerhalb des ASICs durch separate Messwandler.

Nachteilig an dem vorstehend beschriebenen bekannten Differenzstromsensor ist die unbefriedigende Kalibrierung, die sich als nicht besonders genau erwiesen hat.

Ferner ist zum Stand der Technik hinzuweisen auf US 2005/0248351 A1. Diese Druckschrift offenbart eine Messschaltung gemäß dem Oberbegriff des Hauptanspruchs zur Messung einer Batteriespannung, wobei ein Messwandler den Spannungsabfall über einem Strommesswiderstand misst. Der Strommesswiderstand kann hierbei wahlweise mit der Batterie oder mit einer Spannungsreferenz verbunden werden. Der Messwandler selbst misst aber immer den Spannungsabfall über dem Strommesswiderstand und kann nicht mit der Spannungsreferenz verbunden werden. Eine vollständige Kalibrierung ist auf diese Weise nicht möglich.

Ferner ist zum Stand der Technik hinzuweisen auf DE 10 2010 038 851 A1, DE 20 2010 005 756 U1, US 5 319 370 A, US 2007/208520 A1 und DE 10 2004 062 655 A1.

Der Erfindung liegt deshalb die Aufgabe zugrunde, den vorstehend beschriebenen bekannten Differenzstromsensor entsprechend zu verbessern.

Diese Aufgabe wird durch einen erfindungsgemäßen Differenzstromsensor gemäß dem Hauptanspruch gelöst.

Die Erfindung beruht auf der technischen Erkenntnis, dass die unbefriedigenden Ergebnisse bei der Kalibrierung bei dem bekannten Differenzstromsensor daher rühren, dass die Spannungsreferenz einerseits und der Spannungsabfall über dem Strommesswiderstand andererseits durch separate Messwandler erfasst werden. Dies ist nachteilig, weil Messfehler der einzelnen Messwandler auf diese Weise im Rahmen der Kalibrierung nicht ausgeglichen werden können. Die Erfindung umfasst deshalb die allgemeine technische Lehre, dass bei dem erfindungsgemäßen Differenzstromsensor die Spannungsreferenz und der Spannungsabfall über dem Strommesswiderstand von demselben Messwandler gemessen werden, und zwar sowohl spannungsseitig ("high side") als auch masseseitig ("low side"). Die beiden spannungs- bzw. masseseitigen Messwandler messen deshalb bei dem erfindungsgemäßen Differenzstromsensor nacheinander in schneller Folge die jeweilige Spannungsreferenz und den Spannungsabfall über dem jeweiligen Strommesswiderstand.

In einem bevorzugten Ausführungsbeispiel der Erfindung wird die Spannungsreferenz für die Kalibrierung - wie bei dem eingangs beschriebenen bekannten Differenzstromsensor gemäß WO 00/00834 A1 - durch einen Spannungsteiler bereitgestellt, der zwischen den Hinleiter und den Rückleiter geschaltet ist. Hierbei wird eine erste Spannungsreferenz für die Kalibrierung der spannungsseitigen Strommessung durch einen ersten Spannungsabgriff an dem Spannungsteiler gebildet, während eine zweite Spannungsreferenz für die Kalibrierung der masseseitigen Strommessung durch einen zweiten Spannungsabgriff an dem Spannungsteiler gebildet wird.

In dem bevorzugten Ausführungsbeispiel ist der Spannungsteiler so bemessen, dass der erste Spannungsabfall über dem ersten Strommesswiderstand in der gleichen Größenordnung liegt wie die erste Spannungsreferenz. Darüber hinaus ist der Spannungsteiler vorzugsweise auch so bemessen, dass der zweite Spannungsabfall über dem zweiten Strommesswiderstand in der gleichen Größenordnung liegt wie die zweite Spannungsreferenz. Beispielsweise können diese Spannungswerte im Bereich von 30 mV liegen. Diese annähernde Übereinstimmung der Spannungswerte der Spannungsreferenzen einerseits und der Spannungen über den Strommesswiderständen andererseits ist vorteilhaft, weil in diesem Fall der jeweilige Messwandler und ggf. ein zusätzlicher Vorverstärker nacheinander die Spannungsreferenz und den Spannungsabfall über dem jeweiligen Strommesswiderstand messen kann, ohne dass interne Einstellungen in dem Messwandler bzw. dem Vorverstärker geändert werden müssen.

In dem bevorzugten Ausführungsbeispiel der Erfindung weist der Spannungsteiler eine Reihenschaltung auf aus einem spannungsseitigen ersten Widerstand (z.B. R1=100 $\Omega$), einem mittigen zweiten Widerstand (z.B. R2=2 M$\Omega$) und einem masseseitigen dritten Widerstand (z.B. R3=100 Ω). Der mittige zweite Widerstand weist hierbei vorzugsweise einen wesentlich höheren Widerstandswert auf als der spannungsseitige erste Widerstand und auch als der masseseitige dritte Widerstand. Die erste Spannungsreferenz für die spannungsseitige Kalibrierung wird hierbei vorzugsweise durch einen ersten Spannungsabgriff zwischen dem spannungsseitigen Widerstand des Spannungsteilers und dem mittigen Widerstand des Spannungsteilers bereitgestellt. Die zweite Spannungsreferenz für die Kalibrierung der masseseitigen Strommessung wird dagegen vorzugsweise durch einen zweiten Spannungsabgriff zwischen dem masseseitigen dritten Widerstand und dem mittigen Widerstand des Spannungsteilers gebildet.

Vorzugsweise zeigt der Widerstandswert bei dem spannungsseitigen ersten Widerstand des Spannungsteilers und bei dem masseseitigen dritten Widerstand des Spannungsteilers dieselbe Temperaturabhängigkeit. Dies ist vorteilhaft für eine möglichst hohe Temperaturunabhängigkeit bei der Kalibrierung und im Betrieb. Beispielsweise können zum Aufbau des Spannungsteilers Metallschichtwiderstände eingesetzt werden, die aus derselben Charge stammen und deshalb nahezu dieselbe Temperaturabhängigkeit aufweisen. Darüber hinaus können kleine Unterschiede im Temperaturkoeffizienten auch bei der Kalibrierung erfasst und rechnerisch eliminiert werden. Weiterhin ist zu erwähnen, dass die beiden äußeren Widerstände des Spannungsteilers bei dieser Anordnung nur sehr gering belastet werden, so dass eine sehr gute Langzeitstabilität zu erwarten ist.

Die Temperaturunabhängigkeit und die Genauigkeit des hochohmigen mittigen Widerstands des Spannungsteilers spielen dagegen bei der Differenzstrommessung keine oder nur eine geringe Rolle. Vorzugsweise ermöglicht der erfindungsgemäße Differenzstromsensor jedoch auch eine Gesamtspannungsmessung, d.h. eine Messung der Spannung zwischen Hinleiter und Rückleiter, wobei auch für den hochohmigen mittleren Widerstand des Spannungsteilers eine gute Langzeitstabilität und ein guter Gleichlauf des Temperaturkoeffizienten notwendig ist. Beide Forderungen können in idealer Weise mit einem aus einem homogenen Widerstandsmaterial (z.B. Dünnschicht) hergestellten Netzwerk auf Keramik realisiert werden, wobei auch die nötige Spannungsfestigkeit vorhanden ist.

Darüber hinaus weist der erfindungsgemäße Differenzstromsensor vorzugsweise eine elektronische Auswertungseinheit auf, die mit den beiden Messeinrichtungen für die Messung des Spannungsabfalls verbunden ist und in Abhängigkeit von den beiden Spannungsabfällen über dem spannungsseitigen bzw. masseseitigen Strommesswiderstand den Differenzstrom ermittelt.

Zur Erreichung einer möglichst hohen Messgenauigkeit sollte die Spannungsmessung über den Strommesswiderständen auf der Spannungsseite ("high side") und auf der Masseseite ("low side") gleichzeitig erfolgen. Die Auswertungseinheit überträgt deshalb vorzugsweise ein Triggersignal zu den beiden spannungsseitigen bzw. masseseitigen Messeinrichtungen, um die Spannungsmessung zu triggern, so dass die Spannungsmessung masseseitig und spannungsseitig gleichzeitig erfolgt.

Die Datenübertragung zwischen den Messeinrichtungen einerseits und der Auswertungseinheit andererseits erfolgt vorzugsweise durch galvanisch getrennte Datenleitungen, z.B. über Optokoppler.

Die Genauigkeit der Messung kann weiter gesteigert werden, indem die beiden Strommesswiderstände durch eine elektrisch isolierende, aber thermisch leitfähige Wärmebrücke miteinander verbunden werden, um Temperaturunterschiede zwischen den beiden Strommesswiderständen zu vermeiden.

Der störende Einfluss von Temperaturschwankungen lässt sich jedoch auch bei dem erfindungsgemäßen Differenzstromsensor nicht vollständig unterbinden und wird deshalb bei dem erfindungsgemäßen Differenzstromsensor vorzugsweise rechnerisch kompensiert.

Eine zusätzliche thermische Störungsquelle besteht in Thermospannungen im Messkreis (Strommesswiderstand und Messeinrichtung), die von Temperaturdifferenzen über den Strommesswiederständen herrühren. Da die Messeinrichtung grundsätzlich nicht zwischen einer Thermospannung und einem durch einen Stromfluss erzeugten Spannungsabfall unterscheiden kann, muss die Thermospannung indirekt kontinuierlich bestimmt werden. Hierzu weist der erfindungsgemäße Differenzstromsensor vorzugsweise Thermoelemente auf, welche die Temperaturdifferenz über den Strommesswiderständen messen. In Abhängigkeit von der gemessenen Temperaturdifferenz wird dann die resultierende Thermospannung berechnet, wobei diese Berechnung beispielsweise in der jeweiligen Messeinrichtung oder in der Auswertungseinheit (z.B. ASIC) erfolgen kann. Bei der Strommessung erfolgt dann eine entsprechende Kompensation, wobei die Kompensation beispielsweise in der Messeinrichtung oder in der Auswertungseinheit erfolgen kann.

Ein weiterer störender Temperatureinfluss besteht darin, dass der Widerstandswert der Strommesswiderstände auch bei Strommesswiderständen mit einer hohen Temperaturkonstanz geringfügig in Abhängigkeit von der Temperatur schwankt. Der erfindungsgemäße Differenzstromsensor ermöglicht deshalb vorzugsweise eine Kompensation dieser temperaturbedingten Schwankungen des Widerstandswerts der Strommesswiderstände. Hierzu sind vorzugsweise Temperatursensoren vorgesehen, welche die Temperatur des jeweiligen Strommesswiderstands messen. Anschließend wird dann von der Messeinrichtung oder von der Auswertungseinheit die temperaturbedingte Änderung des Widerstandswerts der Strommesswiderstände berechnet und bei der Strommessung kompensierend berücksichtigt.

Für eine hohe Messgenauigkeit ist es weiterhin wichtig, dass die beiden Strommesswiderstände an Masseseite ("low side") und Spannungsseite ("high side") denselben Widerstandswert aufweisen und auch die selbe Temperaturabhängigkeit zeigen.

Es wurde bereits vorstehend erwähnt, dass der erfindungsgemäße Differenzstromsensor die Spannungsreferenz und den Spannungsabfall über dem Strommesswiderstand nacheinander über denselben Messpfad misst, d.h. mit demselben Messwandler. Die Messeinrichtungen an Spannungsseite und Masseseite weisen deshalb vorzugsweise einen Multiplexer auf, der nacheinander den Spannungsabfall über dem jeweiligen Strommesswiderstand und die zugehörige Spannungsreferenz misst.

Darüber hinaus misst der Multiplexer vorzugsweise auch die anderen Größen wie beispielsweise die erste bzw. zweite Temperaturdifferenz und die erste bzw. zweite Temperatur. Ferner ist zu erwähnen, dass die Funktionalitäten der vorstehenden beschriebenen Messeinrichtungen und der Auswertungseinheit vorzugsweise in getrennten elektronischen Bauelementen realisiert werden. Es besteht jedoch im Rahmen der Erfindung auch die Möglichkeit, dass diese Funktionalitäten in einem oder mehreren Bauelementen (z.B. ASICs) integriert sind.

Weiterhin ist zu erwähnen, dass sich der erfindungsgemäße Differenzstromsensor besonders gut für die Messung von Differenzströmen (Fehlerströmen) in Gleichstromnetzen eignet, wie beispielsweise in Kraftfahrzeug-Bordnetzen. Der erfindungsgemäße Differenzstromsensor eignet sich jedoch auch für Wechselstromnetze, insbesondere für Einphasennetze.

Schließlich ist noch zu erwähnen, dass der erfindungsgemäße Differenzstromsensor in dem bevorzugten Ausführungsbeispiel nicht nur den Differenzstrom ausgibt, sondern auch Absolutwerte, wie beispielsweise die Temperaturdifferenzen über den Strommesswiderständen, die Temperaturen der Strommesswiderstände, die Gesamtspannung zwischen Hinleiter und Rückleiter und/oder den Gesamtstrom.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:

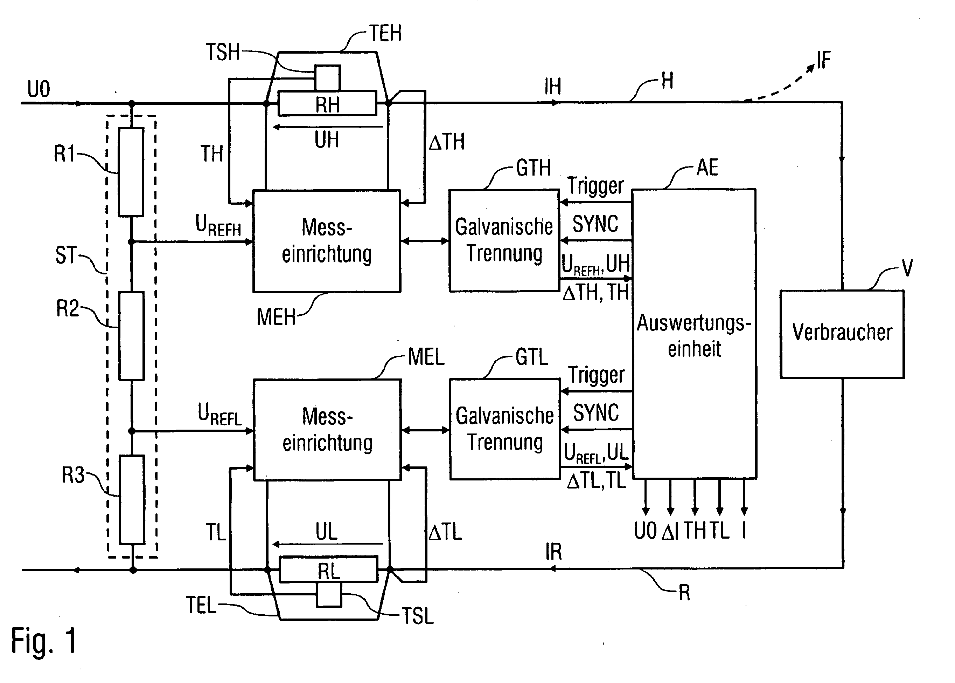

Figur 1    ein schematisches Blockschaltbild eines erfindungsgemäßen Differenzstromsensors, und

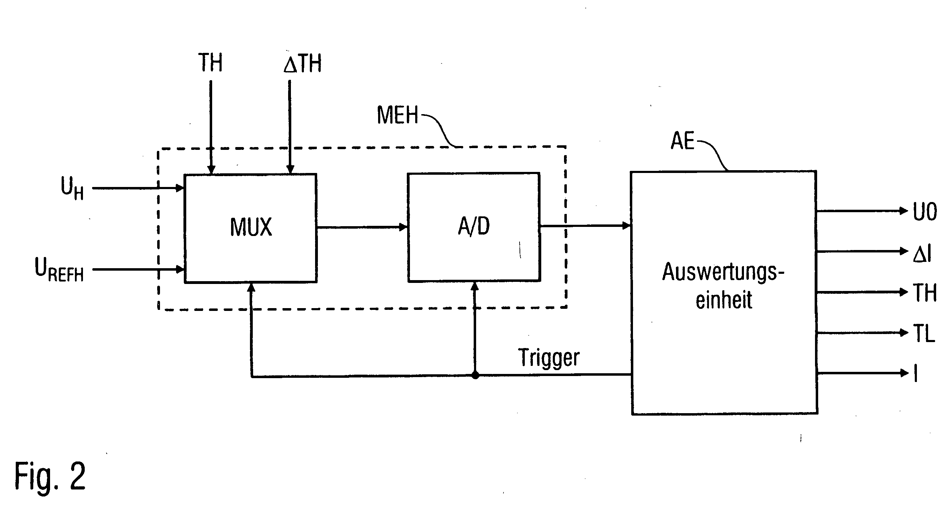

Figur 2    ein vereinfachtes Blockschaltbild der spannungsseitigen Messeinrichtung aus Figur 1, wobei die masseseitige Messeinrichtung entsprechend aufgebaut ist.

Die Zeichnungen zeigen eine schematische Darstellung eines erfindungsgemäßen Differenzstromsensors, der beispielsweise in einem einphasigen Gleichstromnetz verwendet werden kann, um einen Differenzstrom $\Delta I$ zu messen.

Das Gleichstromnetz ist hierbei nur schematisch dargestellt und besteht im Wesentlichen aus einem Hinleiter H, einem Rückleiter R und einem schematisch dargestellten Verbraucher V, wobei durch den Hinleiter H ein elektrischer Strom IH zu dem Verbraucher V fließt, während durch den Rückleiter R ein entsprechender elektrischer Strom IR zurückfließt.

Bei einem fehlerfreien Betrieb entspricht der elektrische Strom IH durch den Hinleiter H exakt dem elektrischen Strom IR durch den Rückleiter R.

Bei einem Fehler kann jedoch ein Fehlerstrom IF von dem Hinleiter H abfließen, beispielsweise bei einem Kurzschluss gegen Masse oder bei Kriechströmen zur Masse. Bei einem solchen Fehler unterscheiden sich die elektrischen Ströme IH, IR in dem Hinleiter H und in dem Rückleiter R um den Differenzstrom $\Delta I$, so dass dann unter Umständen Gegenmaßnahmen (z.B. Notabschaltung) ergriffen werden müssen.

Der erfindungsgemäße Differenzstromsensor ermöglicht deshalb die Messung des spannungsseitigen Stroms IH in dem Hinleiter H und die Messung des masseseitigen Stroms IR in dem Rückleiter R, wobei die Strommessung gemäß der an sich bekannten Vierleitertechnik erfolgt. Hierzu ist in dem Hinleiter H ein niederohmiger Strommesswiderstand RH angeordnet und in dem Rückleiter R befindet sich ein entsprechender weiterer niederohmiger Strommesswiderstand RL.

Bei den beiden niederohmigen Strommesswiderständen RH, RL kann es sich beispielsweise um Strommesswiderstände handeln, wie sie in EP 0 605 800 A1 beschrieben sind, so dass der Inhalt dieser Patentanmeldung der vorliegenden Beschreibung hinsichtlich der Herstellungsweise und des Aufbaus der niederohmigen Strommesswiderstände RH, RL in vollem Umfang zuzurechnen ist.

Zur Messung eines Spannungsabfalls UH über dem spannungsseitigen Strommesswiderstand RH ist eine Messeinrichtung MEH vorgesehen, wie auch für die Messung eines Spannungsabfalls UL über dem masseseitigen Strommesswiderstand RL eine Messeinrichtung MEL vorgesehen ist.

Die spannungsseitige Messeinrichtung MEH ist über eine galvanische Trennung GTH (z.B. Optokoppler) mit einer Auswertungseinheit AE verbunden, wobei die Auswertungseinheit AE über eine weitere galvanische Trennung GTL (z.B. Optokoppler) mit der masseseitigen Messeinrichtung MEL verbunden ist. Die Auswertungseinheit AE empfängt über die beiden galvanischen Trennungen GTH, GTL die Spannungsabfälle UH, UL, die von den beiden Messeinrichtungen MEH, MEL über dem spannungsseitigen Strommesswiderstand RH bzw. über dem masseseitigen Strommesswiderstand RL gemessen werden. Die Datenübertragung über die galvanischen Trennungen GTH, GTL erfolgt hierbei in digitaler Form.

Darüber hinaus ermöglicht der erfindungsgemäße Differenzstromsensor auch eine Kalibrierung mittels eines Spannungsteilers ST, der zwischen den Hinleiter H und den Rückleiter R geschaltet ist, wobei der Spannungsteiler ST aus drei Widerständen R1=100 $\Omega$, R2=2 M$\Omega$, R3=100 $\Omega$ besteht.

Zwischen dem Widerstand R1 und dem Widerstand R2 des Spannungsteilers ST befindet sich hierbei ein Spannungsabgriff, der eine Spannungsreferenz $U_{REFH}$ zur Kalibrierung bereitstellt. Die Messeinrichtung MEH misst mittels eines Multiplexers MUX nacheinander den Spannungsabfall UH über dem Strommesswiderstand RH und die Spannungsreferenz $U_{REFH}$. Wichtig ist hierbei, dass diese Messung über denselben Messpfad erfolgt, wodurch die Kalibrierung wesentlich genauer ist als bei dem eingangs beschriebenen herkömmlichen Differenzstromsensor gemäß WO 00/00834 A1. Die Messeinrichtung MEH überträgt die gemessene Spannungsreferenz $U_{REFH}$ dann über die galvanische Trennung GTH zu der Auswertungseinheit AE.

Zwischen dem Widerstand R2 und dem Widerstand R3 des Spannungsteilers ST befindet sich ein weiterer Spannungsabgriff, der eine masseseitige Spannungsreferenz $U_{REFL}$ zur Kalibrierung der Messeinrichtung MEL bereitstellt. Auch in der Messeinrichtung MEL ist ein Multiplexer MUX vorgesehen, der nacheinander den Spannungsabfall UL über dem Strommesswiderstand RL und die Spannungsreferenz $U_{REFL}$ über denselben Messpfad misst. In den beiden Messeinrichtungen MEH, MEL befindet sich hinter dem Multiplexer MUX ein Analog/Digital-Wandler A/D, so dass die gemessenen Spannungswerte als Digitalsignale zu der Auswertungseinheit AE übertragen werden.

Darüber hinaus ermöglicht der erfindungsgemäße Differenzstromsensor auch eine Kompensation von Thermospannungen, die aufgrund von Temperaturdifferenzen über den Strommesswiderständen RH, RL entstehen. Hierzu weist der erfindungsgemäße Differenzstromsensor zwei Thermoelemente TEH, TEL auf, welche eine Temperaturdifferenz $\Delta TH$ über dem spannungsseitigen Strommesswiderstand RH bzw. eine Temperaturdifferenz $\Delta TL$ über dem masseseitigen Strommesswiderstand RL messen. Diese Messung der Temperaturdifferenzen $\Delta TH$, $\Delta TL$ erfolgt ebenfalls über den Multiplexer MUX der jeweiligen Messeinrichtung MEH, MEL.

Darüber hinaus ermöglicht der erfindungsgemäße Differenzstromsensor auch eine Kompensation von temperaturbedingten Schwankungen des Widerstandswerts der beiden Strommesswiderstände RH, RL. Hierzu sind Temperatursensoren TSH bzw. TSL vorgesehen, welche die Temperatur TH des spannungsseitigen Strommesswiderstands RH bzw. die Temperatur TL des masseseitigen Strommesswiderstands RL messen. Diese Messung der Temperaturen TH, TL erfolgt ebenfalls über den Multiplexer MUX der jeweiligen Messeinrichtung MEH, MEL.

In der Auswertungseinheit AE wird dann in Abhängigkeit von den gemessenen Daten der Differenzstrom $\Delta I$ nach folgender Formel berechnet:

$$\Delta I = IH - IR = \frac{UH_{OHM}}{RH(TH)} - \frac{UL_{OHM}}{RL(TL)}$$

$$= \frac{UH - UH_{THERMO}(\Delta TH)}{RH(TH)} - \frac{UL - UL_{THERMO}(\Delta TL)}{RL(TL)}$$

mit:

IH:         Strom durch den Hinleiter H
IR:         Strom durch den Rückleiter R
$UH_{OHM}$:         Ohmscher Spannungsabfall über dem spannungsseitigen Strommesswiderstand RH
$UL_{OHM}$:         Ohmscher Spannungsabfall über dem masseseitigen Strommesswiderstand RH
$UH_{THERMO}$:         Thermospannung über dem spannungsseitigen Strommesswiderstand RH
$UL_{THERMO}$:         Thermospannung über dem masseseitigen Strommesswiderstand RL
RH:         Temperaturabhängiger Widerstandswert des spannungsseitigen Strommesswiderstands RH
RL:         Temperaturabhängiger Widerstandswert des masseseitigen Strommesswiderstands RH
$\Delta TH$:         Temperaturdifferenz über dem spannungsseitigen Strommesswiderstand RH
$\Delta TL$:         Temperaturdifferenz über dem masseseitigen Strommesswiderstand RL
TH:         Temperatur des spannungsseitigen Strommesswiderstands RH
TL:         Temperatur des spannungsseitigen Strommesswiderstands RL
UH:         Gemessener Spannungsabfall über dem spannungsseitigen Strommesswiderstand RH
UL:         Gemessener Spannungsabfall über dem masseseitigen Strommesswiderstand RL.

Die temperaturabhängigen Verläufe der Widerstandswerte RH(TH) und RL(TL) liegen hierbei als Kennlinien vor und sind in der Auswertungseinheit AE gespeichert.

Darüber hinaus liegen auch die temperaturabhängigen Verläufe der Thermospannungen $UH_{THERMO}(\Delta TH)$ und $UL_{THERMO}(\Delta TL)$ als Kennlinien vor und sind in der Auswertungseinheit AE gespeichert.

Vorteilhaft an dem erfindungsgemäßen Differenzstromsensor ist ferner, dass die Spannungsreferenzen $U_{REFH}$ bzw. $U_{REFL}$ in der gleichen Größenordnung liegen wie die zugehörigen Spannungsabfälle UH bzw. UL. Dies ist vorteilhaft, weil die Messeinrichtungen MEH bzw. MEL dann nacheinander diese Spannungswerte messen können, ohne dass eine interne Umschaltung erforderlich ist.

Darüber hinaus ist zu erwähnen, dass die Auswertungseinheit AE über die galvanischen Trennungen GTH, GTL ein Triggersignal an die beiden Messeinrichtungen MEH, MEL sendet, so dass die Spannungsabfälle UH, UL über den beiden Strommesswiderständen RH, RL nahezu exakt zeitgleich gemessen werden, was zu einer hohen Messgenauigkeit beiträgt.

Ferner überträgt die Auswertungseinheit AE über die beiden galvanischen Trennungen GTH, GTL jeweils ein Synchronisationssignal SYNC an die beiden Messeinrichtungen MEH, MEL, um deren Messungen exakt zu synchronisieren.

Weiterhin ist es wichtig, dass bei der Kalibrierung die Spannungsreferenzen $U_{REFH}$, $U_{REFL}$ einerseits und die jeweiligen Spannungsabfälle UH, UL über denselben Messpfad gemessen werden, was ebenfalls zu einer Verbesserung der Messgenauigkeit beiträgt.

Aus der Zeichnung ist weiterhin ersichtlich, dass die Auswertungseinheit AE neben dem Differenzstrom ΔI weitere Ausgänge aufweist zur Ausgabe eines Gesamtstroms I, der Temperaturen TH, TL und einer Gesamtspannung U0, die zwischen dem Hinleiter H und dem Rückleiter R abfällt.

Die Erfindung ist nicht auf das vorstehend beschriebene bevorzugte Ausführungsbeispiel beschränkt. Vielmehr ist auch eine Vielzahl von Varianten und Abwandlungen möglich, die ebenfalls in den Schutzbereich fallen.

Bezugszeichenliste:

| | |
|---|---|
| ΔI | Differenzstrom |
| ΔTH | Temperaturdifferenz über Strommesswiderstand RH |
| ΔTL | Temperaturdifferenz über Strommesswiderstand RL |
| AE | Auswertungseinheit |
| GTH | Galvanische Trennung an Spannungsseite |
| GTL | Galvanische Trennung an Masseseite |
| H | Hinleiter |
| I | Gesamtstrom |
| IF | Fehlerstrom |
| IH | Strom durch Hinleiter |
| IR | Strom durch Rückleiter |
| MEH | Spannungsseitige Messeinrichtung |
| MEL | Masseseitige Messeinrichtung |
| MUX | Multiplexer |
| R1 | Widerstand |
| R2 | Widerstand |
| R3 | Widerstand |
| RH | Niederohmiger Strommesswiderstand |
| RL | Niederohmiger Strommesswiderstand |
| R | Rückleiter |
| ST | Spannungsteiler |
| SYNC | Synchronisationssignal |
| TEH | Thermoelement an High-Side |
| TEL | Thermoelement an Low-Side |
| TH | Temperatur des Strommesswiderstands an High-Side |
| TL | Temperatur des Strommesswiderstands an Low-Side |
| TSH | Temperatursensor an High-Side |
| TSL | Temperatursensor an Low-Side |
| U0 | Gesamtspannung |
| UH | Spannungsabfall über Strommesswiderstand RH |
| UL | Spannungsabfall über Strommesswiderstand RL |
| $U_{REFH}$ | Spannungsreferenz für High-Side |
| $U_{REFL}$ | Spannungsreferenz für Low-Side |
| V | Verbraucher |

**Patentansprüche**

1. Differenzstromsensor zur Messung eines Differenzstroms ($\Delta I$) zwischen einem ersten elektrischen Strom (IH) durch einen Hinleiter (H) und einem zweiten elektrischen Strom (IR) durch einen Rückleiter (R), insbesondere für ein Gleichstromnetz, mit

   a) einem niederohmigen ersten Strommesswiderstand (RH) zur Messung des ersten elektrischen Stroms (IH) durch den Hinleiter (H), wobei der erste Strommesswiderstand (RH) in dem Hinleiter (H) angeordnet ist und von dem ersten elektrischen Strom (IH) durchflossen wird,
   b) einer ersten Messeinrichtung (MEH) mit einem ersten Messwandler (A/D) zur Messung eines ersten Spannungsabfalls (UH) über dem ersten Strommesswiderstand (RH),
   c) einer ersten Spannungsreferenz ($U_{REFH}$) zur Kalibrierung der ersten Messeinrichtung (MEH),
   d) einem niederohmigen zweiten Strommesswiderstand (RL) zur Messung des zweiten elektrischen Stroms (IR) durch den Rückleiter (R), wobei der zweite Strommesswiderstand (RL) in dem Rückleiter (R) angeordnet ist und von dem zweiten elektrischen Strom (IR) durchflossen wird,
   e) einer zweiten Messeinrichtung (MEL) mit einem zweiten Messwandler (A/D) zur Messung eines zweiten Spannungsabfalls (UL) über dem zweiten Strommesswiderstand (RL),
   f) einer zweiten Spannungsreferenz ($U_{REFL}$) zur Kalibrierung der zweiten Messeinrichtung (MEL),
   **dadurch gekennzeichnet,**
   g) **dass** der erste Messwandler (A/D) so angepasst ist, dass es nacheinander sowohl den ersten Spannungsabfall (UH) über dem ersten Strommesswiderstand (RH) als auch die erste Spannungsreferenz ($U_{REFH}$) misst,
   h) **dass** der zweite Messwandler (A/D) so angepasst ist, dass es nacheinander sowohl den zweiten Spannungsabfall (UL) über dem zweiten Strommesswiderstand (RL) als auch die zweite Spannungsreferenz ($U_{REFL}$) misst.

2. Differenzstromsensor nach Anspruch 1,
   **dadurch gekennzeichnet,**

   a) **dass** zwischen den Hinleiter (H) und den Rückleiter (R) ein Spannungsteiler (R1, R2, R3) aus mehreren Widerständen (R1, R2, R3) geschaltet ist,
   b) **dass** die erste Spannungsreferenz ($U_{REFH}$) durch einen ersten Spannungsabgriff an dem Spannungsteiler (R1, R2, R3) gebildet wird,
   c) **dass** die zweite Spannungsreferenz ($U_{REFL}$) durch einen zweiten Spannungsabgriff an dem Spannungsteiler (R1, R2, R3) gebildet wird.

3. Differenzstromsensor nach Anspruch 2,
   **dadurch gekennzeichnet,**

   a) **dass** der Spannungsteiler (R1, R2, R3) so bemessen ist, dass der erste Spannungsabfall (UH) über dem ersten Strommesswiderstand (RH) in der gleichen Größenordnung liegt wie die erste Spannungsreferenz ($U_{REFH}$) und
   b) **dass** der Spannungsteiler (R1, R2, R3) so bemessen ist, dass der zweite Spannungsabfall (UL) über dem zweiten Strommesswiderstand (RL) in der gleichen Größenordnung liegt wie die zweite Spannungsreferenz ($U_{REFL}$).

4. Differenzstromsensor nach Anspruch 2 oder 3,
   **dadurch gekennzeichnet,**

   a) **dass** der Spannungsteiler (R1, R2, R3) eine Reihenschaltung aufweist aus einem spannungsseitigen ersten Widerstand (R1), einem mittigen zweiten Widerstand (R2) und einem masseseitigen dritten Widerstand (R3),
   b) **dass** der mittige zweite Widerstand (R2) einen wesentlich höheren Widerstandswert aufweist als der spannungsseitig erste Widerstand (R1) und als der masseseitige dritte Widerstand (R3),
   c) **dass** der erste Spannungsabgriff für die erste Spannungsreferenz ($U_{REFH}$) zwischen dem spannungsseitigen ersten Widerstand (R1) und dem mittigen Widerstand (R2) mit der ersten Messeinrichtung (MEH) verbunden ist,
   d) **dass** der zweite Spannungsabgriff für die zweite Spannungsreferenz ($U_{REFL}$) zwischen dem masseseitigen dritten Widerstand (R3) und dem mittigen Widerstand (R2) mit der zweiten Messeinrichtung (MEL) verbunden ist.

5. Differenzstromsensor nach einem der Ansprüche 2 bis 4, **dadurch gekennzeichnet, dass** der Widerstandswert bei dem spannungsseitigen ersten Widerstand (R1) des Spannungsteilers und bei dem masseseitigen dritten Widerstand (R3) des Spannungsteilers im Wesentlichen dieselbe Temperaturabhängigkeit hat.

6. Differenzstromsensor nach einem der Ansprüche 2 bis 5, **dadurch gekennzeichnet,**

 a) **dass** der Spannungsteiler (R1, R2, R3) einen keramischen Träger aufweist, und
 b) **dass** die Widerstände (R1, R2, R3) des Spannungsteilers (R1, R2, R3) als homogenes Widerstandsmaterial auf den keramischen Träger aufgebracht sind, insbesondere als Dünnschichtnetzwerk.

7. Differenzstromsensor nach einem der vorhergehenden Ansprüche, **gekennzeichnet durch** eine elektronische Auswertungseinheit (AE), die mit der ersten Messeinrichtung (MEH) und mit der zweiten Messeinrichtung (MEL) verbunden ist und in Abhängigkeit von dem ersten Spannungsabfall (UH) und dem zweiten Spannungsabfall (UL) den Differenzstrom ($\Delta$I) ermittelt.

8. Differenzstromsensor nach Anspruch 7, **dadurch gekennzeichnet, dass** die Auswertungseinheit (AE) ein Triggersignal (Trigger) und/oder ein Taktsignal (SYNC) zu der ersten Messeinrichtung (MEH) und zu der zweiten Messeinrichtung (MEL) überträgt und dadurch eine gleichzeitige Messung durch die erste Messeinrichtung (MEH) und durch die zweite Messeinrichtung (MEL) triggert.

9. Differenzstromsensor nach einem der vorhergehenden Ansprüche, **dadurch gekennzeichnet,**

 a) **dass** ein erstes Thermoelement (TEH) vorgesehen ist zur Messung einer ersten Temperaturdifferenz ($\Delta$TH) über dem ersten Strommesswiderstand (RH),
 b) **dass** die erste Messeinrichtung (MEH) oder die Auswertungseinheit (AE) in Abhängigkeit von der ersten Temperaturdifferenz ($\Delta$TH) eine erste Thermospannung berechnet, die über dem ersten Strommesswiderstand (RH) abfällt,
 c) **dass** die erste Messeinrichtung (MEH) oder die Auswertungseinheit (AE) die erste Thermospannung ($\Delta$TH) bei der Strommessung berücksichtigt,
 d) **dass** ein zweites Thermoelement (TEL) vorgesehen ist zur Messung einer zweiten Temperaturdifferenz ($\Delta$TL) über dem zweiten Strommesswiderstand (RL),
 e) **dass** die zweite Messeinrichtung (MEL) oder die Auswertungseinheit (AE) in Abhängigkeit von der zweiten Temperaturdifferenz ($\Delta$TL) eine zweite Thermospannung berechnet, die über dem zweiten Strommesswiderstand (RL) abfällt,
 f) **dass** die zweite Messeinrichtung (MEL) oder die Auswertungseinheit (AE) die zweite Thermospannung ($\Delta$TL) bei der Strommessung berücksichtigt.

10. Differenzstromsensor nach einem der vorhergehenden Ansprüche, **dadurch gekennzeichnet,**

 a) **dass** ein erster Temperatursensor (TSH) vorgesehen ist zur Messung einer ersten Temperatur (TH) des ersten Strommesswiderstands (RH),
 b) **dass** die erste Messeinrichtung (MEH) oder die Auswertungseinheit (AE) in Abhängigkeit von der ersten Temperatur (TH) eine temperaturbedingte Änderung des Widerstandswerts des ersten Strommesswiderstands berechnet,
 c) **dass** die erste Messeinrichtung (MEH) oder die Auswertungseinheit (AE) die temperaturbedingte Änderung des Widerstandswerts bei der Strommessung berücksichtigt,
 d) **dass** ein zweiter Temperatursensor (TSL) vorgesehen ist zur Messung einer zweiten Temperatur (TL) des zweiten Strommesswiderstands (RL),
 e) **dass** die zweite Messeinrichtung (MEL) oder die Auswertungseinheit (AE) in Abhängigkeit von der zweiten Temperatur (TL) eine temperaturbedingte Änderung des Widerstandswerts des zweiten Strommesswiderstands (RL) berechnet,
 f) **dass** die erste Messeinrichtung (MEH) oder die Auswertungseinheit (AE) die temperaturbedingte Änderung des Widerstandswerts bei der Strommessung berücksichtigt.

11. Differenzstromsensor nach einem der Ansprüche 7 bis 10, **gekennzeichnet durch**

 a) eine galvanisch getrennte erste Datenleitung (GTH) zwischen der ersten Messeinrichtung (MEH) und der Auswertungseinheit (AE)

  a1) zur Übertragung des ersten Spannungsabfalls (UH) von der ersten Messeinrichtung (MEH) zu der Auswertungseinheit (AE) und/oder

a2) zur Übertragung des Triggersignals von der Auswertungseinheit (AE) zu der ersten Messeinrichtung (MEH), und/oder

a3) zur Übertragung der ersten Temperaturdifferenz ($\Delta$TH) von der ersten Messeinrichtung (MEH) zu der Auswertungseinheit (AE), und/oder

a4) zur Übertragung der ersten Temperatur (TH) von der ersten Messeinrichtung (MEH) zu der Auswertungseinheit (AE), und

b) eine galvanisch getrennte zweite Datenleitung (GTL) zwischen der zweiten Messeinrichtung (MEL) und der Auswertungseinheit (AE)

b1) zur Übertragung des zweiten Spannungsabfalls (UH) von der zweiten Messeinrichtung (MEL) zu der Auswertungseinheit (AE) und/oder

b2) zur Übertragung des Triggersignals von der Auswertungseinheit (AE) zu der zweiten Messeinrichtung (MEL), und/oder

b3) zur Übertragung der zweiten Temperaturdifferenz ($\Delta$TL) von der zweiten Messeinrichtung (MEL) zu der Auswertungseinheit (AE), und/oder

b4) zur Übertragung der zweiten Temperatur (TH) von der zweiten Messeinrichtung (MEL) zu der Auswertungseinheit (AE).

12. Differenzstromsensor nach einem der vorhergehenden Ansprüche, **dadurch gekennzeichnet, dass** der erste Strommesswiederstand (RH) durch eine elektrisch isolierende, aber thermisch leitfähige Wärmebrücke thermisch mit dem zweiten Strommesswiderstand (RL) verbunden ist, um einen Temperaturunterschied zwischen den beiden Strommesswiderständen (RH, RL) zu minimieren.

13. Differenzstromsensor nach einem der vorhergehenden Ansprüche, **dadurch gekennzeichnet,**

a) **dass** der erste Strommesswiderstand (RH) und der zweite Strommesswiderstand (RL) denselben Widerstandswert haben, und/oder

b) **dass** der Widerstandswert bei dem ersten Strommesswiderstand (RH) und bei dem zweiten Strommesswiderstand (RL) im Wesentlichen dieselbe Temperaturabhängigkeit hat.

14. Differenzstromsensor nach einem der vorhergehenden Ansprüche, **dadurch gekennzeichnet,**

a) **dass** die erste Messeinrichtung (MEH) einen ersten Multiplexer (MUX) aufweist, wobei der erste Messwandler (A/D) über den ersten Multiplexer (MUX) nacheinander den ersten Spannungsabfall (UH) über dem ersten Strommesswiderstand (RH) und die erste Spannungsreferenz ($U_{REFH}$) misst,

b) **dass** die zweite Messeinrichtung (MEL) einen zweiten Multiplexer (MUX) aufweist, wobei der zweite Messwandler (A/D) über den zweiten Multiplexer (MUX) nacheinander den zweiten Spannungsabfall (UL) über dem zweiten Strommesswiderstand (RL) und die zweite Spannungsreferenz ($U_{RFFL}$) misst.

15. Differenzstromsensor nach einem der vorhergehenden Ansprüche, **dadurch gekennzeichnet, dass** der Differenzstromsensor mindestens eine der folgenden Größen ausgibt:

a) den Differenzstrom ($\Delta$I),

b) eine Gesamtspannung (U0), die zwischen dem Hinleiter (H) und dem Rückleiter (R) abfällt,

c) den ersten elektrischen Strom (IH) oder eine davon abgeleitete Stromgröße,

d) den zweiten elektrischen Strom (IR) oder eine davon abgeleitete Stromgröße,

e) die erste Temperaturdifferenz ($\Delta$TH) oder eine davon abgeleitete Größe,

f) die zweite Temperaturdifferenz ($\Delta$TL) oder eine davon abgeleitete Größe,

g) die erste Temperatur (TH) oder eine davon abgeleitete Größe,

h) die zweite Temperatur (TL) oder eine davon abgeleitete Größe.

16. Stromnetz, insbesondere Gleichstromnetz, insbesondere Kraftfahrzeug-Bordnetz, mit einem Differenzstromsensor nach einem der vorhergehenden Ansprüche.

**Claims**

1. A differential current sensor for measuring a differential current ($\Delta$I) between a first electric current (IH) through a delivery conductor (H) and a second electric current (IR) through a return conductor (R), in particular for a direct-current power supply system, with

> a) a low-ohmic first current-sense resistor (RH) for measuring the first electric current (IH) through the delivery conductor (H), wherein the first current-sense resistor (RH) is arranged in the delivery conductor (H) and the first electric current (IH) flows through it,
> b) a first measuring device (MEH) with a first measuring transducer (A/D) for measuring a first voltage drop (UH) over the first current-sense resistor (RH),
> c) a first voltage reference ($U_{REFH}$) for calibrating the first measuring device (MEH),
> d) a low-ohmic second current-sense resistor (RL) for measuring the second electric current (IR) through the return conductor (R), wherein the second current-sense resistor (RL) is arranged in the return conductor (R) and the second electric current (IR) flows through it,
> e) a second measuring device (MEL) with a second measuring transducer (A/D) for measuring a second voltage drop (UL) over the second current-sense resistor (RH),
> f) a second voltage reference ($U_{REFL}$) for calibrating the second measuring device (MEL),
> **characterized in that**
> g) the first measuring transducer (A/D) is adapted so that it successively measures both the first voltage drop (UH) over the first current-sense resistor (RH) and the first voltage reference ($U_{REFH}$),
> h) the second measuring transducer (A/D) is adapted so that it successively measures both the second voltage drop (UL) over the second current current-sense resistor (RL) and the second voltage reference ($U_{REFL}$).

2. The differential current sensor according to Claim 1, **characterized in that**

> a) a voltage divider (R1, R2, R3) made up of a plurality of resistors (R1, R2, R3) is connected between the delivery conductor (H) and the return conductor (R),
> b) the first voltage reference ($U_{REFH}$) is formed by a first voltage tapping point on the voltage divider (R1, R2, R3),
> c) the second voltage reference ($U_{REFL}$) is formed by a second voltage tapping point on the voltage divider (R1, R2, R3).

3. The differential current sensor according to Claim 2, **characterized in that**

> a) the voltage divider (R1, R2, R3) is dimensioned in such a manner that the first voltage drop (UH) over the first current-sense resistor (RH) is of the same order of magnitude as the first voltage reference ($U_{REFH}$), and
> b) the voltage divider (R1, R2, R3) is dimensioned in such a manner that the second voltage drop (UL) over the second current-sense resistor (RL) is of the same order of magnitude as the second voltage reference ($U_{REFL}$).

4. The differential current sensor according to Claim 2 or 3, **characterized in that**

> a) the voltage divider (R1, R2, R3) has a series circuit made up of a voltage-side first resistor (R1), a central second resistor (R2) and a ground-side third resistor (R3),
> b) the central second resistor (R2) has a substantially higher resistance value than the voltage-side first resistor (R1) and than the ground-side third resistor (R3),
> c) the first voltage tapping point for the first voltage reference ($U_{REFH}$) is connected to the first measuring device (MEH) between the voltage-side first resistor (R1) and the central resistor (R2),
> d) the second voltage tapping point for the second voltage reference ($U_{REFL}$) is connected to the second measuring device (MEL) between the ground-side third resistor (R3) and the central resistor (R2).

5. The differential current sensor according to any one of Claims 2 to 4, **characterized in that** the resistance value at the voltage-side first resistor (R1) of the voltage divider and at the ground-side third resistor (R3) of the voltage divider essentially has the same temperature dependence.

6. The differential current sensor according to any one of Claims 2 to 5, **characterized in that**

> a) the voltage divider (R1, R2, R3) has a ceramic support, and
> b) the resistors (R1, R2, R3) of the voltage divider (R1, R2, R3) are applied as homogeneous resistance material onto the ceramic support, in particular as a thin-film network.

7. The differential current sensor according to any one of the preceding claims, **characterized by** an electronic evaluation unit (AE), which is connected to the first measuring device (MEH) and to the second measuring device (MEL) and determines the differential current (ΔI) as a function of the first voltage drop (UH) and the second voltage drop (UL).

8. The differential current sensor according to Claim 7, **characterized in that** the evaluation unit (AE) transmits a triggering signal (trigger) and/or a clock signal (SYNC) to the first measuring device (MEH) and to the second measuring device (MEL) and as a result triggers a simultaneous measurement by the first measuring device (MEH) and by the second measuring device (MEL).

9. The differential current sensor according to any one of the preceding claims, **characterized in that**

a) a first thermocouple (TEH) is provided for measuring a first temperature difference (ΔTH) over the first current-sense resistor (RH),
b) the first measuring device (MEH) or the evaluation unit (AE) calculates a first thermoelectric potential as a function of the first temperature difference (ΔTH), which drops over the first current-sense resistor (RH),
c) the first measuring device (MEH) or the evaluation unit (AE) takes account of the first thermoelectric potential (ΔTH) during the current measurement,
d) a second thermocouple (TEL) is provided for measuring a second temperature difference (ΔTL) over the second current-sense resistor (RL),
e) the second measuring device (MEL) or the evaluation unit (AE) calculates a second thermoelectric potential as a function of the second temperature difference (ΔTL), which drops over the second current-sense resistor (RL),
f) the second measuring device (MEL) or the evaluation unit (AE) takes account of the second thermoelectric potential (ΔTL) during the current measurement.

10. The differential current sensor according to any one of the preceding claims, **characterized in that**

a) a first temperature sensor (TSH) is provided for measuring a first temperature (TH) of the first current-sense resistor (RH),
b) the first measuring device (MEH) or the evaluation unit (AE) calculates a temperature-related change of the resistance value of the first current-sense resistor as a function of the first temperature (TH),
c) the first measuring device (MEH) or the evaluation unit (AE) takes account of the temperature-related change of the resistance value during the current measurement,
d) a second temperature sensor (TSL) is provided for measuring a second temperature (TL) of the second current-sense resistor (RH),
e) the second measuring device (MEL) or the evaluation unit (AE) calculates a temperature-related change of the resistance value of the second current-sense resistor (RL) as a function of the second temperature (TL),
f) the first measuring device (MEH) or the evaluation unit (AE) takes account of the temperature-related change of the resistance value during the current measurement.

11. The differential current sensor according to any one of Claims 7 to 10, **characterized by**

a) a galvanically separated first data line (GTH) between the first measuring device (MEH) and the evaluation unit (AE)

a1) for transmitting the first voltage drop (UH) from the first measuring device (MEH) to the evaluation unit (AE) and/or
a2) for transmitting the triggering signal from the evaluation unit (AE) to the first measuring device (MEH), and/or
a3) for transmitting the first temperature difference (ΔTH) from the first measuring device (MEH) to the evaluation unit (AE) and/or
a4) for transmitting the first temperature (TH) from the first measuring device (MEH) to the evaluation unit (AE), and

b) a galvanically separated second data line (GTL) between the second measuring device (MEL) and the evaluation unit (AE)

b1) for transmitting the second voltage drop (UH) from the second measuring device (MEL) to the evaluation unit (AE) and/or

b2) for transmitting the triggering signal from the evaluation unit (AE) to the second measuring device (MEL), and/or

b3) for transmitting the second temperature difference ($\Delta$TL) from the second measuring device (MEL) to the evaluation unit (AE), and/or

b4) for transmitting the second temperature (TH) from the second measuring device (MEL) to the evaluation unit (AE).

12. The differential current sensor according to any one of the preceding claims, **characterized in that** the first current-sense resistor (RH) is thermally connected to the second current-sense resistor (RL) by means of an electrically insulating, but thermally conductive heat bridge, in order to minimize a temperature difference between the two current-sense resistors (RH, RL).

13. The differential current sensor according to any one of the preceding claims, **characterized in that**

a) the first current-sense resistor (RH) and the second current-sense resistor (RL) have the same resistance value, and/or

b) the resistance value at the first current-sense resistor (RH) and at the second current-sense resistor (RL) essentially has the same temperature dependence.

14. The differential current sensor according to any one of the preceding claims, **characterized in that**

a) the first measuring device (MEH) has a first multiplexer (MUX), wherein the first measuring transducer (A/D) successively measures the first voltage drop (UH) over the first current-sense resistor (RH) and the first voltage reference (U$_{REFH}$) by means of the first multiplexer (MUX),

b) the second measuring device (MEL) has a second multiplexer (MUX), wherein the second measuring transducer (A/D) successively measures the second voltage drop (UL) over the second current-sense resistor (RL) and the second voltage reference (U$_{REFL}$) by means of the second multiplexer (MUX).

15. The differential current sensor according to any one of the preceding claims, **characterized in that** the differential current sensor outputs at least one of the following values:

a) the differential current ($\Delta$I),

b) a total voltage (U0) which drops between the delivery conductor (H) and the return conductor (R),

c) the first electric current (IH) or a current value derived therefrom,

d) the second electric current (IR) or a current value derived therefrom,

e) the first temperature difference ($\Delta$TH) or a value derived therefrom,

f) the second temperature difference ($\Delta$TL) or a value derived therefrom,

g) the first temperature (TH) or a value derived therefrom,

h) the second temperature (TL) or a value derived therefrom.

16. A power supply system, in particular a direct-current power supply system, in particular a motor vehicle electrical system, with a differential current sensor according to any one of the preceding claims.

**Revendications**

1. Détecteur de courant différentiel servant à la mesure d'un courant différentiel ($\Delta$I) entre un premier courant électrique (IH) par le biais d'un conducteur aller (H) et un second courant électrique (IR) par le biais d'un conducteur retour (R), en particulier pour un réseau à courant continu, pourvu

a) d'une première résistance de mesure de courant (RH) de faible valeur ohmique servant à la mesure du premier courant électrique (IH) par le biais du conducteur aller (H), sachant que la première résistance de mesure de courant (RH) est disposée dans le conducteur aller (H) et est parcourue par le premier courant électrique (IH),

b) d'un premier dispositif de mesure (MEH) ayant un premier convertisseur de mesure (A/N) servant à la mesure d'une première chute de tension (UH) aux bornes de la première résistance de mesure de courant (RH),

c) d'une première tension de référence ($U_{REFH}$) servant au calibrage du premier dispositif de mesure (MEH),

d) d'une seconde résistance de mesure de courant (RL) de faible valeur ohmique servant à la mesure du second courant électrique (IR) par le biais du conducteur retour (R), sachant que la seconde résistance de mesure de courant (RL) est disposée dans le conducteur retour (R) et est parcourue par le second courant électrique (IR),

e) d'un second dispositif de mesure (MEL) ayant un second convertisseur de mesure (A/N) servant à la mesure d'une seconde chute de tension (UL) aux bornes de la seconde résistance de mesure de courant (RL),

f) d'une seconde tension de référence ($U_{REFL}$) servant au calibrage du second dispositif de mesure (MEL),

**caractérisé**

g) **en ce que** le premier convertisseur de mesure (A/N) est adapté de sorte qu'il mesure l'une après l'autre aussi bien la première chute de tension (UH) aux bornes de la première résistance de mesure de courant (RH) que la première tension de référence ($U_{REFH}$),

h) **en ce que** le second convertisseur de mesure (A/N) est adapté de sorte qu'il mesure l'une après l'autre aussi bien la seconde chute de tension (UL) aux bornes de la seconde résistance de mesure de courant (RL) que la seconde tension de référence ($U_{REFL}$).

2. Détecteur de courant différentiel selon la revendication 1,
**caractérisé**

a) **en ce qu'**un diviseur de tension (R1, R2, R3) composé de plusieurs résistances (R1, R2, R3) est monté entre le conducteur aller (H) et le conducteur retour (R),

b) **en ce que** la première tension de référence ($U_{REFH}$) est formée par un premier prélèvement de tension sur le diviseur de tension (R1, R2, R3),

c) **en ce que** la seconde tension de référence ($U_{REFL}$) est formée par un second prélèvement de tension sur le diviseur de tension (R1, R2, R3).

3. Détecteur de courant différentiel selon la revendication 2,
**caractérisé**

a) **en ce que** le diviseur de tension (R1, R2, R3) est dimensionné de sorte que la première chute de tension (UH) aux bornes de la première résistance de mesure de courant (RH) soit du même ordre de grandeur que la première tension de référence ($U_{REFH}$), et

b) **en ce que** le diviseur de tension (R1, R2, R3) est dimensionné de sorte que la seconde chute de tension (UL) aux bornes de la seconde résistance de mesure de courant (RL) soit du même ordre de grandeur que la seconde tension de référence ($U_{REFL}$).

4. Détecteur de courant différentiel selon la revendication 2 ou 3,
**caractérisé**

a) **en ce que** le diviseur de tension (R1, R2, R3) présente un circuit en série composé d'une première résistance côté tension (R1), d'une deuxième résistance centrale (R2) et d'une troisième résistance côté masse (R3),

b) **en ce que** la deuxième résistance centrale (R2) présente une valeur ohmique sensiblement plus élevée que la première résistance côté tension (R1) et que la troisième résistance côté masse (R3),

c) **en ce que** le premier prélèvement de tension pour la première tension de référence ($U_{REFH}$) entre la première résistance côté tension (R1) et la résistance centrale (R2) est relié au premier dispositif de mesure (MEH),

d) **en ce que** le second prélèvement de tension pour la seconde tension de référence ($U_{REFL}$) entre la troisième résistance côté masse (R3) et la résistance centrale (R2) est relié au second dispositif de mesure (MEL).

5. Détecteur de courant différentiel selon l'une quelconque des revendications 2 à 4,
**caractérisé en ce que** la valeur ohmique de la première résistance côté tension (R1) du diviseur de tension et celle de la troisième résistance côté masse (R3) du diviseur de tension ont sensiblement la même variabilité avec la température.

6. Détecteur de courant différentiel selon l'une quelconque des revendications 2 à 5,
**caractérisé**

a) **en ce que** le diviseur de tension (R1, R2, R3) présente un support céramique et

b) **en ce que** les résistances (R1, R2, R3) du diviseur de tension (R1, R2, R3) sont appliquées sur le support céramique en tant que matériau résistif homogène, en particulier en tant que réseau en couches minces.

**7.** Détecteur de courant différentiel selon l'une quelconque des revendications précédentes, **caractérisé par** une unité d'évaluation électronique (AE) qui est reliée au premier dispositif de mesure (MEH) et au second dispositif de mesure (MEL) et qui détermine le courant différentiel ($\Delta$I) en fonction de la première chute de tension (UH) et de la seconde chute de tension (UL).

**8.** Détecteur de courant différentiel selon la revendication 7, **caractérisé en ce que** l'unité d'évaluation (AE) transmet un signal de déclenchement (Trigger) et/ou un signal d'horloge (SYNC) au premier dispositif de mesure (MEH) et au second dispositif de mesure (MEL) et déclenche de ce fait une mesure simultanée par le premier dispositif de mesure (MEH) et par le second dispositif de mesure (MEL).

**9.** Détecteur de courant différentiel selon l'une quelconque des revendications précédentes, **caractérisé**

a) **en ce qu'**il est prévu un premier élément thermique (TEH) pour la mesure d'une première différence de température ($\Delta$TH) aux bornes de la première résistance de mesure de courant (RH),
b) **en ce que** le premier dispositif de mesure (MEH) ou l'unité d'évaluation (AE) calcule en fonction de la première différence de température ($\Delta$TH) une première tension thermique qui est présente aux bornes de la première résistance de mesure de courant (RH),
c) **en ce que** le premier dispositif de mesure (MEH) ou l'unité d'évaluation (AE) tient compte de la première tension thermique ($\Delta$TH) lors de la mesure de courant,
d) **en ce qu'**il est prévu un second élément thermique (TEL) pour la mesure d'une seconde différence de température ($\Delta$TL) aux bornes de la seconde résistance de mesure de courant (RL),
e) **en ce que** le second dispositif de mesure (MEL) ou l'unité d'évaluation (AE) calcule en fonction de la seconde différence de température ($\Delta$TL) une seconde tension thermique qui est présente aux bornes de la seconde résistance de mesure de courant (RL),
f) **en ce que** le second dispositif de mesure (MEL) ou l'unité d'évaluation (AE) tient compte de la seconde tension thermique ($\Delta$TL) lors de la mesure de courant.

**10.** Détecteur de courant différentiel selon l'une quelconque des revendications précédentes, **caractérisé**

a) **en ce qu'**il est prévu une première sonde de température (TSH) pour la mesure d'une première température (TH) de la première résistance de mesure de courant (RH),
b) **en ce que** le premier dispositif de mesure (MEH) ou l'unité d'évaluation (AE) calcule, en fonction de la première température (TH) un changement variable avec la température de la valeur ohmique de la première résistance de mesure de courant,
c) **en ce que** le premier dispositif de mesure (MEH) ou l'unité d'évaluation (AE) tient compte du changement variable avec la température de la valeur ohmique lors de la mesure de courant,
d) **en ce qu'**il est prévu une seconde sonde de température (TSL) pour la mesure d'une seconde température (TL) de la seconde résistance de mesure de courant (RL),
e) **en ce que** le second dispositif de mesure (MEL) ou l'unité d'évaluation (AE) calcule en fonction de la seconde température (TL) un changement variable avec la température de la valeur ohmique de la seconde résistance de mesure de courant (RL),
f) **en ce que** le premier dispositif de mesure (MEH) ou l'unité d'évaluation (AE) tient compte du changement variable avec la température de la valeur ohmique lors de la mesure de courant.

**11.** Détecteur de courant différentiel selon l'une quelconque des revendications 7 à 10, **caractérisé par**

a) une première ligne de données à séparation galvanique (GTH) entre le premier dispositif de mesure (MEH) et l'unité d'évaluation (AE), destinée à

a1) la transmission de la première chute de tension (UH) du premier dispositif de mesure (MEH) à l'unité d'évaluation (AE) et/ou
a2) la transmission du signal de déclenchement de l'unité d'évaluation (AE) au premier dispositif de mesure (MEH), et/ou
a3) la transmission de la première différence de température ($\Delta$TH) du premier dispositif de mesure (MEH) à l'unité d'évaluation (AE), et/ou
a4) la transmission de la première température (TH) du premier dispositif de mesure (MEH) à l'unité d'évaluation (AE), et

b) une seconde ligne de données à séparation galvanique (GTL) entre le second dispositif de mesure (MEL) et l'unité d'évaluation (AE), destinée à b1) la transmission de la seconde chute de tension (UH) du second dispositif de mesure (MEL) à l'unité d'évaluation (AE) et/ou

b2) la transmission du signal de déclenchement de l'unité d'évaluation (AE) au second dispositif de mesure (MEL), et/ou

b3) la transmission de la seconde différence de température ($\Delta$TL) du second dispositif de mesure (MEL) à l'unité d'évaluation (AE), et/ou

b4) la transmission de la seconde température (TH) du second dispositif de mesure (MEL) à l'unité d'évaluation (AE).

**12.** Détecteur de courant différentiel selon l'une quelconque des revendications précédentes, **caractérisé en ce que** la première résistance de mesure de courant (RH) est reliée à la seconde résistance de mesure de courant (RL) de manière thermique par un pont thermique, isolant électrique mais conducteur thermique, afin de rendre minimale une différence de température entre les deux résistances de mesure de courant (RH, RL).

**13.** Détecteur de courant différentiel selon l'une quelconque des revendications précédentes, **caractérisé**

a) **en ce que** la première résistance de mesure de courant (RH) et la seconde résistance de mesure de courant (RL) ont la même valeur ohmique, et/ou

b) **en ce que** la valeur ohmique de la première résistance de mesure de courant (RH) et celle de la seconde résistance de mesure de courant (RL) ont sensiblement la même variabilité avec la température.

**14.** Détecteur de courant différentiel selon l'une quelconque des revendications précédentes, **caractérisé**

a) **en ce que** le premier dispositif de mesure (MEH) présente un premier multiplexeur (MUX), sachant que le premier convertisseur de mesure (A/N) mesure par le biais du premier multiplexeur (MUX) l'une après l'autre la première chute de tension (UH) aux bornes de la première résistance de mesure de courant (RH) et la première tension de référence ($U_{REFH}$),

b) **en ce que** le second dispositif de mesure (MEL) présente un second multiplexeur (MUX), sachant que le second convertisseur de mesure (A/N) mesure par le biais du second multiplexeur (MUX) l'une après l'autre la seconde chute de tension (UL) aux bornes de la seconde résistance de mesure de courant (RL) et la seconde tension de référence ($U_{REFL}$).

**15.** Détecteur de courant différentiel selon l'une quelconque des revendications précédentes, **caractérisé en ce que** le détecteur de courant différentiel délivre en sortie au moins l'une des grandeurs suivantes :

a) le courant différentiel ($\Delta$I),

b) une tension totale (UO) qui est présente entre le conducteur aller (H) et le conducteur retour (R),

c) le premier courant électrique (IH) ou une grandeur de courant qui en est déduite,

d) le second courant électrique (IR) ou une grandeur de courant qui en est déduite,

e) la première différence de température ($\Delta$TH) ou une grandeur qui en est déduite,

f) la seconde différence de température ($\Delta$TL) ou une grandeur qui en est déduite,

g) la première température (TH) ou une grandeur qui en est déduite,

h) la seconde température (TL) ou une grandeur qui en est déduite.

**16.** Réseau électrique, en particulier réseau à courant continu, en particulier réseau de bord d'un véhicule automobile, pourvu d'un détecteur de courant différentiel selon l'une quelconque des revendications précédentes.

Fig. 1

EP 2 593 798 B1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0000834 A1
- US 20050248351 A1
- DE 102010038851 A1
- DE 202010005756 U1
- US 5319370 A
- US 2007208520 A1
- DE 102004062655 A1
- EP 0605800 A1